# DEMANDE DE BREVET EUROPEEN

(11) **EP 4 601 195 A1**
(43) Date de publication de la demande: **13.08.2025**
(21) Numéro de dépôt: 25155695.7
(22) Date de dépôt: 04.02.2025
(51) Int. Cl.: H03K 17/725, H03K 17/13, H03K 17/61, H03K 17/723

(54) **DISPOSITIF DE COMMUTATION DE CHARGE**

(30) Priorité: 07.02.2024 FR 2401204
(71) Demandeur: STMicroelectronics International N.V., 1228 Plan-les-Ouates, Geneva (CH)
(72) Inventeur: BENABDELAZIZ, Ghafour, 37100 TOURS (FR)
(74) Mandataire: Cabinet Beaumont

(57) **Abrégé**

La présente description concerne un dispositif (100) de commutation de charge (1006), comprenant deux thyristors de puissance (102, 104) couplés tête-bêche l'un à l'autre, et un thyristor de commande (106) dont l'anode est couplée à la gâchette d'un premier des deux thyristors de puissance (102) et dont la cathode est couplée à l'anode du premier des deux thyristors de puissance (102) ;
et dans lequel :
- la gâchette d'un deuxième des deux thyristors de puissance (104) est couplée à une première entrée de commande (114) du dispositif, et la gâchette du thyristor de commande est couplée à une deuxième entrée de commande (116) du dispositif, distincte de la première entrée de commande, ou
- la gâchette du thyristor de commande et la gâchette du deuxième des deux thyristors de puissance sont couplées à une même entrée de commande du dispositif.

## Description

### Domaine technique

La présente description concerne de façon générale le domaine de la commutation de charge couplée à un réseau électrique.

### Technique antérieure

Pour commander la commutation d'une charge dans un circuit électrique couplé à un réseau électrique fournissant par exemple une tension électrique alternative, il est possible d'utiliser un triac de puissance couplé électriquement en série à la charge au sein du circuit électrique. Toutefois, des problèmes de réamorçage intempestif du triac peuvent se produire lorsque la commande n'est plus appliqué sur la gâchette du triac, ces problèmes étant liés à la variation maximum de la tension à l'état bloqué du triac (correspondant au problème de dV/dt à la commutation du triac) et à la variation maximum de l'intensité du courant direct traversant le triac (correspondant au problème de di/dt à la commutation du triac), en particulier lorsque la charge dont la commutation commandée est inductive. Ces problèmes de réamorçage sont dus à une quantité trop importante de charges électriques accumulées dans le triac et qui doivent être extraites lors de son ouverture.

Pour éviter ces problèmes de réamorçage, il est possible d'utiliser, à la place du triac, deux thyristors montés tête-bêche, c'est-à-dire couplés l'un à l'autre et tels que la cathode de l'un soit reliée à l'anode de l'autre. En effet, contrairement au triac, étant donné que les thyristors utilisés dans cette configuration sont deux composants distincts, les charges accumulées par l'un de deux thyristors ne sont pas vues par l'autre lors de leur blocage. De plus, lorsque le courant circulant dans un des thyristors s'annule pour changer de polarité, ce dernier ne peux se réamorcer car il se trouve alors polarisé en inverse et le courant va circuler à travers l'autre thyristor. Un autre avantage apporté par l'utilisation de deux thyristors par rapport au triac est le plus faible niveau du courant requis pour leur commande. Néanmoins, ce dernier avantage est contrebalancé par le fait que deux signaux de commande distincts sont nécessaires pour commander ces deux thyristors. En effet, la référence de chaque signal de commande, connecté sur la cathode du thyristor, n'est pas identique, ce qui rend difficile l'obtention de ces deux signaux.

Une solution permettant d'avoir deux signaux de commande avec deux références distinctes consiste à réaliser une isolation galvanique entre les gâchettes des deux thyristors. Cette isolation galvanique est par exemple formée en utilisant un transformateur d'impulsion doté d'un primaire sur lequel un seul signal de commande est appliqué, et de deux secondaires distincts sur lesquels les signaux de commande appliqués sur les gâchettes des deux thyristors sont obtenus. Un tel transformateur a toutefois pour inconvénient d'être encombrant et coûteux en raison des deux secondaires nécessaires. De plus, cette solution nécessite des diodes de redressement couplées aux gâchettes des thyristors. En outre, cette solution est source d'interférences électromagnétiques, est difficilement intégrable et offre une faible précision de commande pour la commutation à tension nulle (ou ZVS pour « Zero-Voltage Switching » en anglais) des thyristors.

Une autre solution pour former cette isolation galvanique consiste à utiliser un opto-triac comprenant un triac dont chacune des anodes est couplée à l'une des gâchettes des deux thyristors, et un opto-coupleur. Dans cette autre solution, c'est le courant provenant du réseau qui est utilisé pour former les signaux de commande des thyristors, limité par la charge et la résistance d'anode de l'opto-triac, ce qui suppose la présence d'une tension de réseau minimale pour amorcer les thyristors. Un tel opto-triac a également pour inconvénient de nécessiter un buffer et des diodes de redressement couplées aux gâchettes des thyristors. De plus, cette solution est difficilement intégrable et offre une faible précision de commande pour la commutation à tension nulle des thyristors.

### Résumé de l'invention

Il existe un besoin de proposer une solution permettant de répondre aux problèmes rencontrés avec les solutions existantes.

Un mode de réalisation pallie tout ou partie des inconvénients des solutions connues et propose un dispositif de commutation de charge, comprenant deux thyristors de puissance couplés tête-bêche l'un à l'autre, et un thyristor de commande dont l'anode est couplée à la gâchette d'un premier des deux thyristors de puissance et dont la cathode est couplée à l'anode du premier des deux thyristors de puissance.

Selon un mode de réalisation particulier, l'anode du premier des deux thyristors de puissance est couplée à un potentiel électrique de référence.

Selon un mode de réalisation particulier, la gâchette d'un deuxième des deux thyristors de puissance est couplée à une première entrée de commande du dispositif de commutation de charge, et la gâchette du thyristor de commande est couplée à une deuxième entrée de commande du dispositif de commutation de charge, distincte de la première entrée de commande.

Selon un mode de réalisation particulier, la gâchette du thyristor de commande et la gâchette d'un deuxième des deux thyristors de puissance sont couplées à une même entrée de commande du dispositif de commutation de charge.

Selon un mode de réalisation particulier, le premier thyristor de puissance est activé par la conduction inverse du thyristor de commande.

Selon un mode de réalisation particulier, le dispositif de commutation de charge comporte en outre un transformateur comprenant un primaire couplé à l'entrée de commande du dispositif de commutation de charge et un secondaire couplé aux gâchettes du thyristor de commande et du deuxième des deux thyristors de puissance.

Selon un mode de réalisation particulier, le dispositif de commutation de charge comporte en outre un circuit d'écrêtage de tension couplé aux bornes du primaire du transformateur.

Selon un mode de réalisation particulier, le circuit d'écrêtage de tension comporte une diode et une diode zener couplées l'une à l'autre telles que :
- la cathode de la diode est couplée à l'une des bornes du primaire du transformateur ;
- l'anode de la diode est couplée à l'anode de la diode zener ;
- la cathode de la diode zener est couplée à l'autre des bornes du primaire du transformateur.

Selon un mode de réalisation particulier, le dispositif de commutation de charge comporte en outre un transistor comprenant l'une des électrodes de source ou de drain couplée au primaire du transformateur, dans lequel l'autre des électrodes de source ou de drain du transistor et l'une des bornes du primaire du transformateur sont configurées pour former des bornes d'entrée d'une tension d'alimentation, et dans lequel la grille du transistor est couplée à l'entrée de commande du dispositif de commutation de charge.

Selon un mode de réalisation particulier, la gâchette du thyristor de commande et la gâchette du deuxième des deux thyristors de puissance sont chacune couplée à une résistance électrique.

Il est également proposé un circuit électrique comprenant :
- deux bornes d'entrée sur lesquelles une tension électrique alternative est destinée à être appliquée ;
- une charge électrique comprenant une première électrode couplée à l'une des deux bornes d'entrée du circuit électrique ;
- un dispositif de commutation de charge selon un mode de réalisation particulier, couplé entre une deuxième électrode de la charge électrique et l'autre des deux bornes d'entrée du circuit électrique.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente un circuit électrique comprenant un premier exemple de dispositif de commutation de charge selon un mode de réalisation particulier ;
la figure 2 représente des tensions obtenues dans le circuit électrique de la figure 1 lors de son fonctionnement ;
la figure 3 représente des courants inverses obtenus pour deux thyristors de commande différents, en fonction de la valeur du courant appliqué sur leur gâchette ;
la figure 4 représente des valeurs de rapports courant inverse / courant de gâchette obtenus pour deux thyristors de commande différents ;
la figure 5 et la figure 6 représentent des signaux de tension et de courant obtenus dans le circuit électrique de la figure 1 lorsque la charge électrique commutée est résistive ;
la figure 7 et la figure 8 représentent des signaux de tension et de courant obtenus dans le circuit électrique de la figure 1 lorsque la charge électrique commutée est inductive ;
la figure 9 représente un circuit électrique comprenant un deuxième exemple de dispositif de commutation de charge selon un mode de réalisation particulier ;
la figure 10 représente un circuit électrique comprenant un troisième exemple de dispositif de commutation de charge selon un mode de réalisation particulier.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, différents éléments (thyristor, circuit de commande, transformateur, etc.) du circuit électrique et du dispositif de commutation de charge ne sont pas détaillés. L'homme du métier sera capable de réaliser de manière détaillée ces éléments à partir de la description donnée ici.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments. De plus, le terme « couplé » est utilisé ici pour désigner un couplage électrique entre plusieurs éléments (composants, circuits, etc.) électriques et/ou électroniques.

Sauf précision contraire, les expressions "environ", "approximativement", "sensiblement", et "de l'ordre de" signifient à 10 % près, de préférence à 5 % près.

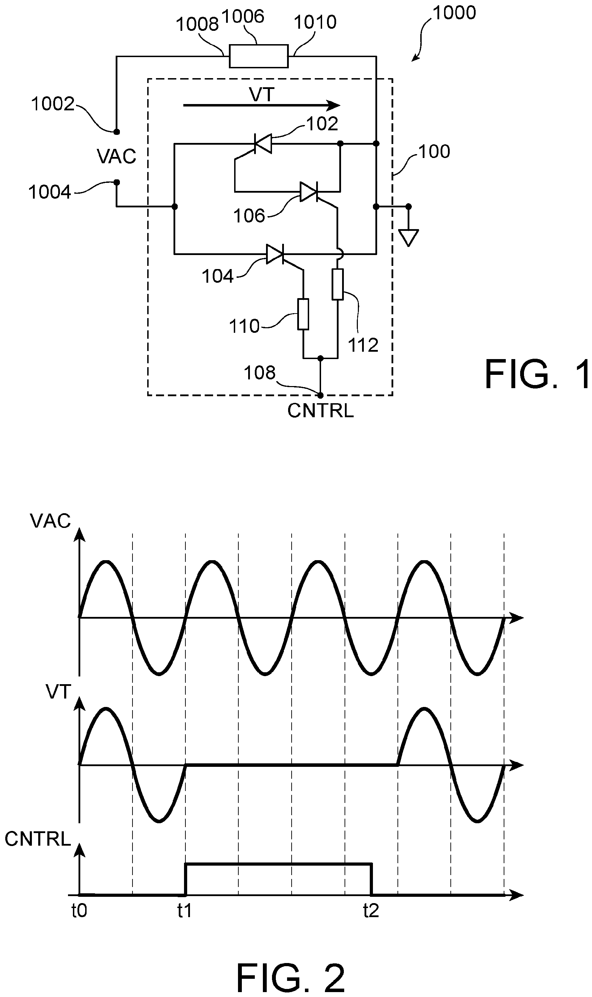

Un circuit électrique 1000 comprenant un premier exemple de dispositif 100 de commutation de charge selon un mode de réalisation particulier est décrit ci-dessous en lien avec la figure 1.

Le circuit 1000 comporte deux bornes d'entrée 1002, 1004 sur lesquelles une tension électrique alternative, appelée VAC sur la figure 1, est destinée à être appliquée, cette tension électrique alternative correspondant par exemple à une tension de réseau domestique telle qu'une tension monophasée.

Le circuit 1000 comporte également une charge électrique 1006 comprenant une première électrode 1008 couplée à l'une des deux bornes d'entrée du circuit 1000 (à la borne 1002 sur l'exemple de la figure 1). La charge 1006 comprend également une deuxième électrode 1010 destinée à être couplée par intermittence à l'autre des deux bornes d'entrée (à la borne 1004 sur l'exemple de la figure 1) du circuit 1000. Pour obtenir ce couplage par intermittence, le circuit 1000 comporte un dispositif 100 de commutation de charge couplé entre la deuxième électrode 1010 de la charge électrique 1006 et l'autre borne d'entrée 1004 du circuit 1000.

Le dispositif 100 comprend deux thyristors de puissance 102, 104 couplés tête-bêche l'un à l'autre. Sur l'exemple de la figure 1, le premier thyristor de puissance 102 comporte son anode couplée à un potentiel électrique de référence, par exemple la masse, et à la deuxième électrode 1010 de la charge 1006. Sur l'exemple de la figure 1, la cathode du premier thyristor de puissance 102 est couplée à la borne d'entrée 1004 du circuit 1000. De plus, sur l'exemple de la figure 1, le deuxième thyristor de puissance 104 comporte son anode couplée à la borne d'entrée 1004 du circuit 1000 (et donc également à la cathode du premier thyristor de puissance 102) et sa cathode couplée au potentiel électrique de référence (et donc également à l'anode du premier thyristor de puissance 102 et à la deuxième électrode 1010 de la charge 1006) .

Le dispositif 100 comporte en outre un thyristor de commande 106 dont l'anode est couplée à la gâchette du premier thyristor de puissance 102 et dont la cathode est couplée à l'anode du premier thyristor de puissance 102.

Dans le premier exemple de dispositif 100 représenté sur la figure 1, la gâchette du thyristor de commande 106 et la gâchette du deuxième thyristor de puissance 104 sont couplées à une même entrée de commande 108 du dispositif 100.

De plus, dans le premier exemple de dispositif 100 représenté sur la figure 1, la gâchette du thyristor de commande 106 et la gâchette du deuxième thyristor de puissance 104 sont chacune couplées à une résistance électrique 110, 112 distincte pour chacune des gâchettes.

La figure 2 représente des courbes de tensions obtenues dans le circuit 1000 de la figure 1 lors de son fonctionnement, avec une charge électrique 1006 correspondant à une charge résistive.

La tension VAC correspond à la tension alternative appliquée sur les bornes d'entrée 1002, 1004 du circuit 1000. Le signal CNTRL correspond au signal de commande appliqué sur l'entrée de commande 108 du dispositif 100. La tension VT correspond à la tension obtenue aux bornes des premier et deuxième thyristors de puissance 102, 104.

Sur la figure 2, entre les instants t0 et t1, le signal de commande CNTRL est nul et les thyristors de puissance 102, 104 sont bloqués. La tension VT obtenue correspond donc à une tension alternative en phase avec la tension VAC.

A l'instant t1, la valeur du signal de commande CNTRL devient positive et engendre le passage d'un courant d'amorçage dans les gâchettes du deuxième thyristor de puissance 104 et du thyristor de commande 106. Sur l'exemple de la figure 1, l'instant t1 correspond également au passage par zéro, depuis une valeur négative vers une valeur positive, de la tension VT. Lorsque la tension VAC est positive, un courant inverse traversant le thyristor de commande 106 est envoyé à la gâchette du premier thyristor de puissance 102, ce qui entraîne l'amorçage et la mise à l'état passant du premier thyristor de puissance 102. Lorsque la tension VAC devient ensuite négative, le deuxième thyristor de puissance 104 s'amorce et passe à l'état passant.

Entre les instants t1 et t2, le signal de commande CNTRL reste à une valeur positive et les thyristors de puissance 102, 104 sont passants. La tension VT est donc sensiblement nulle, et chacun des thyristors de puissance 102, 104 conduit le courant circulant à travers la charge 1006 et le dispositif 100, l'un conduisant le courant lorsque sa valeur est positive (le premier thyristor de puissance 102 sur l'exemple de la figure 1) et l'autre conduisant le courant lorsque sa valeur est négative (le deuxième thyristor de puissance 104 sur l'exemple de la figure 1).

A partir de l'instant t2, le signal de commande CNTRL redevient nul. Dès que la tension VT passe par zéro, les thyristors 102, 104 repassent à l'état bloqué, et la tension VT redevient une tension alternative en phase avec la tension VAC.

Ainsi, le thyristor de commande 106 forme un composant de pilotage, c'est-à-dire un driver, contrôlant en inverse le premier thyristor de puissance 102, du fait qu'il forme une source de courant commandant le courant de gâchette du premier thyristor de puissance 102. La valeur du courant inverse du thyristor de commande 106 dépend de la valeur du courant circulant dans la gâchette du thyristor de commande 106.

A titre d'exemple, les thyristors de puissance 102, 104 peuvent être dimensionnés pour pouvoir conduire des courants de puissance de plusieurs ampères ou plusieurs dizaines ou centaines d'ampère, tandis que le thyristor de commande 106 peut être dimensionné pour conduire un courant de commande de valeur maximale inférieure à 1 A, par exemple inférieure ou égale à 200 mA.

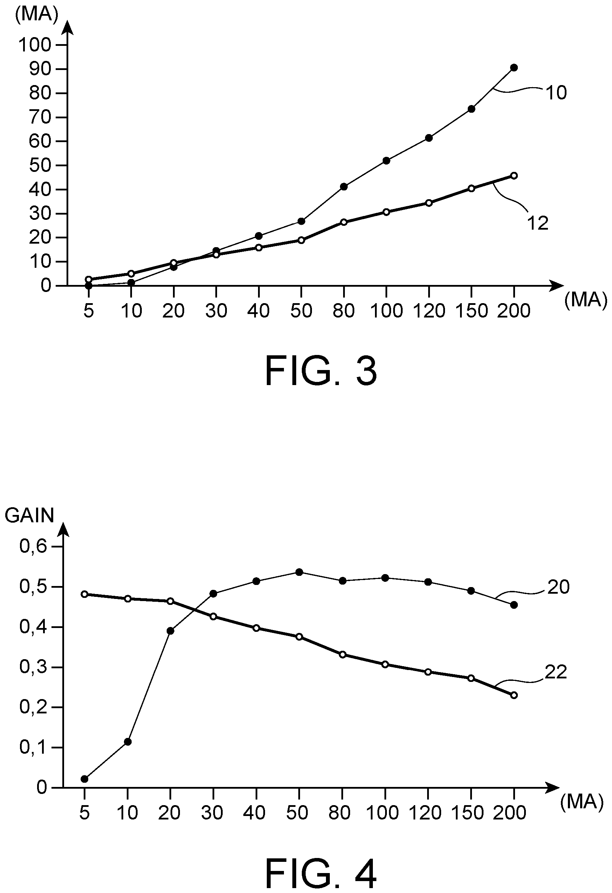

Les courbes 10 et 12 visibles sur la figure 3 représentent des valeurs de courant inverse obtenues pour deux thyristors de commande différents, en fonction de la valeur du courant appliqué sur leur gâchette. Les courbes 20 et 22 visibles sur la figure 4 représentent des valeurs des rapports courant inverse / courant de gâchette obtenus pour ces thyristors de commande.

Dans le circuit 1000, la valeur du courant de puissance destiné à traverser la charge 1006 et les thyristors de puissance 102, 104 dépend de la valeur d'impédance de la charge électrique 1006 et de la tension VAC. Les thyristors de puissance 102, 104 peuvent donc être dimensionnés et choisis en fonction de la valeur de ce courant de puissance. Le thyristor de commande 106 peut ensuite être choisi et dimensionné en fonction du courant de commande requis pour la commande du premier thyristor de puissance 102, c'est-à-dire tel que le thyristor de commande 106 puisse générer un courant inverse suffisant pour servir de courant de commande du premier thyristor de puissance 102.

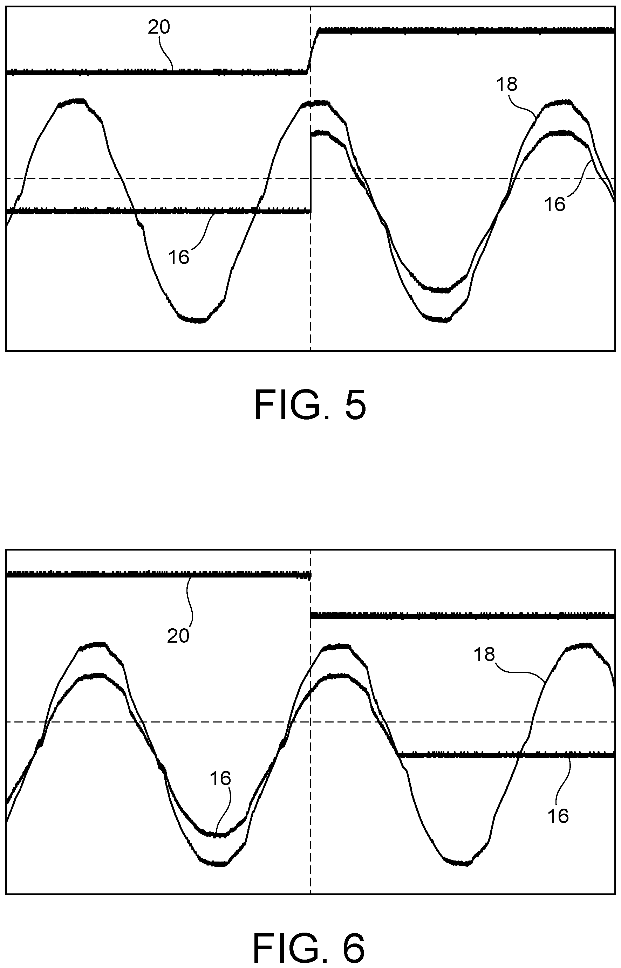

Sur les figures 5 et 6, la référence 16 désigne la valeur du courant circulant dans une charge électrique 1006 résistive et le dispositif 100, la référence 18 désigne la tension VAC et la référence 20 désigne le signal de commande CNTRL. Comme cela est visible sur la figure 5, le courant dans la charge électrique 1006 est nul tant que la valeur du signal de commande CNTRL est nulle. Lorsque la valeur du signal de commande CNTRL devient positive, un courant non nul circule alors dans la charge électrique 1006 et le dispositif 100, en phase avec la tension VAC. Ensuite, comme cela est visible sur la figure 6, lorsque la valeur du signal de commande CNTRL redevient nulle, la valeur du courant traversant la charge électrique 1006 et le dispositif 100 redevient nulle dès que la tension VAC passe par une valeur nulle.

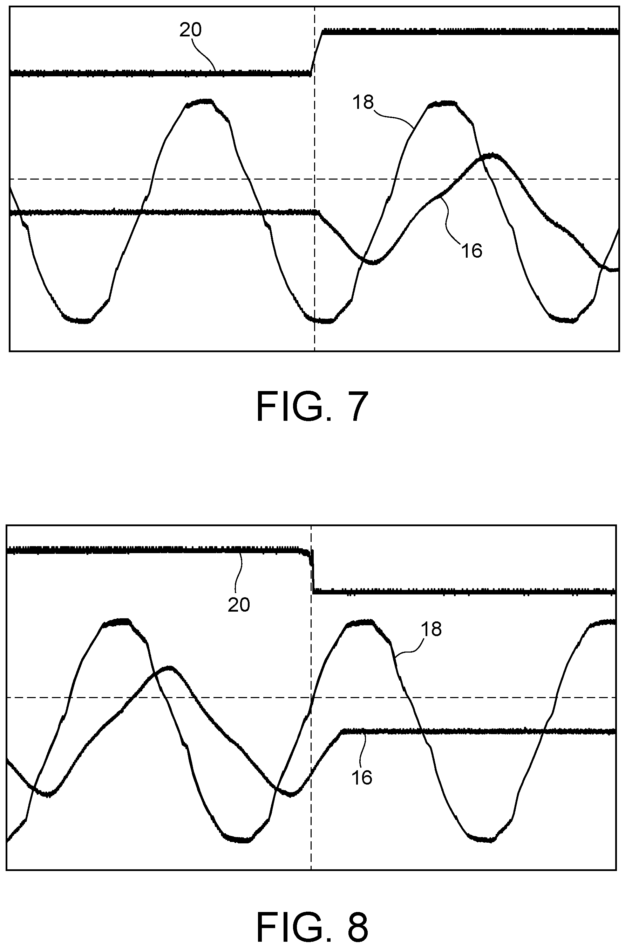

Les signaux 16, 18 et 20 représentés sur les figures 7 et 8 sont similaires à ceux précédemment décrits en lien avec les figures 5 et 6, mais dans le cas où la charge électrique 1006 est inductive. Dans cette configuration, lorsqu'un courant non nul circule dans la charge électrique 1006 et le dispositif 100, ce courant est déphasé par rapport à la tension VAC.

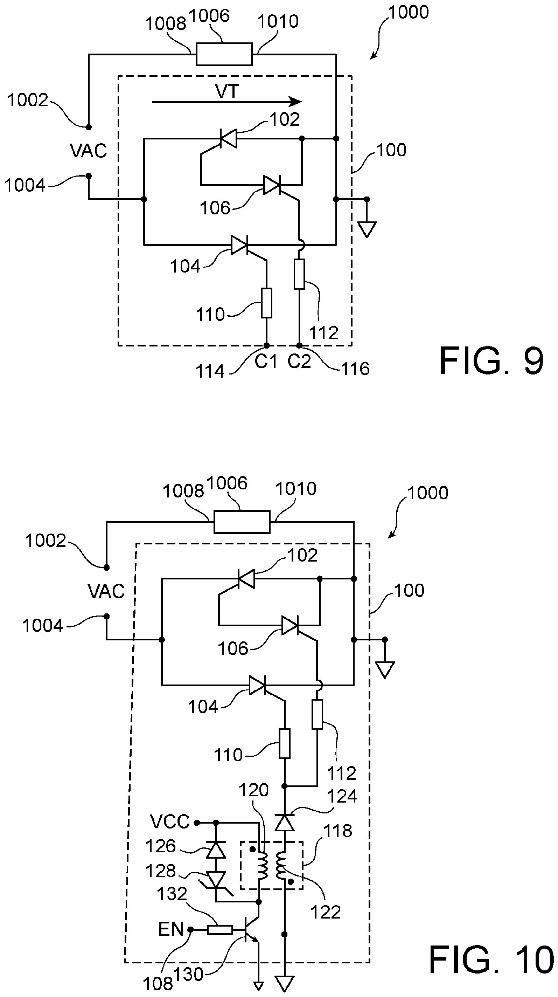

Un deuxième exemple de circuit électrique 1000 comprenant un dispositif 100 de commutation de charge selon un mode de réalisation particulier est décrit ci-dessous en lien avec la figure 9.

Le circuit électrique 1000 selon ce deuxième exemple de réalisation comporte les mêmes éléments que ceux du premier exemple précédemment décrit. Toutefois, contrairement au premier exemple dans lequel les gâchettes du thyristor de commande 106 et du deuxième thyristor de puissance 104 sont couplées à une même entrée de commande 108 du dispositif 100, la gâchette du deuxième thyristor de puissance 104 est couplée à une première entrée de commande 114 du dispositif 100, et la gâchette du thyristor de commande 106 est couplée à une deuxième entrée de commande 116 du dispositif 100, distincte de la première entrée de commande 114. Des signaux de commande distincts, par exemple appelés C1 et C2 sur la figure 9, sont appliqués sur ces entrées de commande 114, 116. Le fonctionnement du dispositif 100 dans ce deuxième exemple est similaire à celui du dispositif 100 selon le premier exemple précédemment décrit, les signaux C1 et C2 étant par exemple similaires au signal de commande CNTRL précédemment décrit en lien avec le premier exemple.

Un troisième exemple de circuit électrique 1000 comprenant un dispositif 100 de commutation de charge selon un mode de réalisation particulier est décrit ci-dessous en lien avec la figure 10.

Le circuit électrique 1000 selon ce troisième exemple de réalisation comporte les mêmes éléments que ceux du premier exemple précédemment décrit. Par contre, dans ce troisième exemple, le dispositif 100 comporte en outre une isolation galvanique réalisée entre la partie commande du dispositif 100 et la partie puissance du dispositif 100. Selon un exemple de réalisation correspondant à celui représenté sur la figure 10, cette isolation galvanique peut être obtenue par un transformateur 118 comprenant un primaire 120 couplé à l'entrée de commande 108 du dispositif 100 et un secondaire 122 couplé aux gâchettes du thyristor de commande 106 et du deuxième thyristor de puissance 104.

Sur l'exemple de la figure 10, le dispositif 100 comporte en outre une diode 124 couplée entre les résistances électriques 110, 112 et une première borne du secondaire 122 du transformateur 118. Une deuxième borne du secondaire 122 du transformateur 118 est couplée au potentiel électrique de référence du circuit 1000.

Sur l'exemple de la figure 10, le dispositif 100 comporte en outre un circuit d'écrêtage de tension couplé aux bornes du primaire 120 du transformateur 118. Selon un exemple de réalisation, ce circuit d'écrêtage de tension comporte une diode 126 et une diode zener 128 couplées l'une à l'autre telles que :
- la cathode de la diode 126 est couplée à l'une des bornes du primaire 120 du transformateur 118 et à un potentiel électrique d'alimentation (VCC) du dispositif 100 ;
- l'anode de la diode 126 est couplée à l'anode de la diode zener 128 ;
- la cathode de la diode zener 128 est couplée à l'autre des bornes du primaire 120 du transformateur 118.

En variante, le circuit d'écrêtage de tension pourrait être réalisé différemment du circuit représenté sur la figure 10.

Dans l'exemple de réalisation décrit, le dispositif 100 comporte en outre un transistor 130 comprenant l'une de ses électrodes de source ou de drain couplée à l'une des bornes du primaire 120 du transformateur 118. L'autre électrode de source ou de drain du transistor 130 est couplée au potentiel électrique de référence du dispositif 100. En outre, la grille du transistor 130 est couplée à l'entrée de commande 108 du dispositif 100 à travers une autre résistance électrique 132.

En variante, un circuit d'écrêtage de tension, similaire ou différent de celui précédemment décrit en lien avec le dispositif de la figure 10, pourrait être couplé à chacune des entrées de commande 114, 116 du dispositif 100 précédemment décrit en lien avec la figure 9.

Parmi les avantages apportés par le dispositif 100, pour tous les exemples de réalisation, il est possible de mentionner ceux ci-dessous :
- pas de problème de réamorçage intempestif si la commande n'est plus appliquée lorsque le courant de puissance s'annule, comme c'est le cas lorsqu'un triac est utilisé pour la commutation de la charge dans le circuit électrique ;
- possibilité de n'avoir qu'un seul signal de commande pour réaliser la commutation de charge ;
- absence des inconvénients présentés par un transformateur d'impulsion ou un opto-triac ;
- consommation électrique réduite grâce à l'utilisation du thyristor de commande ;
- meilleure précision de la commande pour la commutation à tension nulle des thyristors par rapport à un transformateur d'impulsion ou un opto-triac ;
- meilleure intégration du dispositif.

Le dispositif 100 peut être utilisé dans un circuit électrique 1000 d'un appareil dans le domaine industriel, dans un appareil électroménager, dans un véhicule électrique, etc.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en œuvre pratique des modes de réalisation et variantes décrits est à la portée de la personne du métier à partir des indications fonctionnelles données ci-dessus.

## Revendications

1. Dispositif (100) de commutation de charge (1006), comprenant deux thyristors de puissance (102, 104) couplés tête-bêche l'un à l'autre, et un thyristor de commande (106) dont l'anode est couplée à la gâchette d'un premier des deux thyristors de puissance (102) et dont la cathode est couplée à l'anode du premier des deux thyristors de puissance (102) ;
et dans lequel :
- la gâchette d'un deuxième des deux thyristors de puissance (104) est couplée à une première entrée de commande (114) du dispositif (100) de commutation de charge (1006), et la gâchette du thyristor de commande (106) est couplée à une deuxième entrée de commande (116) du dispositif (100) de commutation de charge (1006), distincte de la première entrée de commande (114), ou
- la gâchette du thyristor de commande (106) et la gâchette d'un deuxième des deux thyristors de puissance (104) sont couplées à une même entrée de commande (108) du dispositif (100) de commutation de charge (1006).

2. Dispositif (100) de commutation de charge (1006) selon la revendication 1, dans lequel l'anode du premier des deux thyristors de puissance (102) est couplée à un potentiel électrique de référence.

3. Dispositif (100) de commutation de charge (1006) selon l'une des revendications précédentes, comportant en outre un transformateur (118) comprenant un primaire (120) couplé à l'entrée de commande (108) du dispositif (100) de commutation de charge (1006) et un secondaire (122) couplé aux gâchettes du thyristor de commande (106) et du deuxième des deux thyristors de puissance (104).

4. Dispositif (100) de commutation de charge (1006) selon la revendication 3, comportant en outre un circuit d'écrêtage de tension couplé aux bornes du primaire (120) du transformateur (118).

5. Dispositif (100) de commutation de charge (1006) selon la revendication 4, dans lequel le circuit d'écrêtage de tension comporte une diode (126) et une diode zener (128) couplées l'une à l'autre telles que :
- la cathode de la diode (126) est couplée à l'une des bornes du primaire (120) du transformateur (118) ;
- l'anode de la diode (126) est couplée à l'anode de la diode zener (128) ;
- la cathode de la diode zener (128) est couplée à l'autre des bornes du primaire (120) du transformateur (118).

6. Dispositif (100) de commutation de charge (1006) selon l'une des revendications 3 à 5, comportant en outre un transistor (130) comprenant l'une des électrodes de source ou de drain couplée au primaire (120) du transformateur (118), dans lequel l'autre des électrodes de source ou de drain du transistor (130) et l'une des bornes du primaire (120) du transformateur (118) sont configurées pour former des bornes d'entrée d'une tension d'alimentation, et dans lequel la grille du transistor (130) est couplée à l'entrée de commande (108) du dispositif (100) de commutation de charge (1006).

7. Dispositif (100) de commutation de charge (1006) selon l'une des revendications précédentes, dans lequel la gâchette du thyristor de commande (106) et la gâchette du deuxième des deux thyristors de puissance (104) sont chacune couplée à une résistance électrique (110, 112).

8. Circuit électrique (1000) comprenant :
- deux bornes d'entrée (1002, 1004) sur lesquelles une tension électrique alternative est destinée à être appliquée ;
- une charge électrique (1006) comprenant une première électrode (1008) couplée à l'une des deux bornes d'entrée (1002) du circuit électrique (1000) ;
- un dispositif (100) de commutation de charge (1006) selon l'une des revendications précédentes, couplé entre une deuxième électrode (1010) de la charge électrique (1006) et l'autre des deux bornes d'entrée (1004) du circuit électrique (1000).
